# EUROPEAN PATENT SPECIFICATION

(11) **EP 4 398 449 B1**
(45) Date of publication and mention of the grant of the patent: **21.10.2026**
(21) Application number: 23860924.2
(22) Date of filing: 31.08.2023
(51) Int. Cl.: H02J 7/00, G01R 31/3835, H02J 7/54, H02J 7/90

(54) **SERIAL TYPE CHARGING AND DISCHARGING DEVICE, AND CHARGING AND DISCHARGING METHOD USING SAME**
SERIELLE LADE- UND ENTLADEVORRICHTUNG SOWIE LADE- UND ENTLADEVERFAHREN DAMIT
DISPOSITIF DE CHARGE ET DE DÉCHARGE DE TYPE EN SÉRIE ET PROCÉDÉ DE CHARGE ET DE DÉCHARGE L'UTILISANT

(30) Priority: 01.09.2022 KR 20220110611; 29.08.2023 KR 20230113881
(43) Date of publication of application: 10.07.2024
(73) Proprietor: LG Energy Solution, Ltd., Seoul 07335 (KR)
(72) Inventor: LEE, Han Jin, Daejeon 34122 (KR); LEE, Chan Hee, Daejeon 34122 (KR); JANG, Min Young, Daejeon 34122 (KR); JEONG, Yeon Woo, Daejeon 34122 (KR); YEO, Chang Sin, Daejeon 34122 (KR)
(74) Representative: Goddar, Heinz J.
(86) International application number: PCT/KR2023/013023
(87) International publication number: WO 2024/049249

(56) References cited:
- EP-A2- 1 014 533
- KR-A- 20120 028 350
- KR-A- 20120 117 413
- KR-A- 20140 134 925
- KR-A- 20170 100 341
- KR-B1- 102 429 765
- KR-B1- 102 431 931
- US-A- 5 578 914

## Description

### [Technical Field]

This application claims the benefit of priority to Korean Patent Application No. 10-2022-0110611, filed on September 01, 2022, and Korean Patent Application No. 10-2023-0113881, filed on August 29, 2023.

The present invention relates to a device for charging and discharging a plurality of battery cells connected in series, and a method of charging and discharging using the same.

### [Background Art]

A secondary battery is a battery that can be charged and discharged repeatedly, and a secondary battery can be described as a reversible redox reaction through the electrolyte of two electrodes with a large difference in ionization tendency, which is the process of generating electrical energy.

In general, charging and discharging devices for lithium secondary batteries charge the batteries in a constant current/constant voltage charging method. Constant current/constant voltage charging refers to charging at a constant current up to a target voltage and then charging at a constant voltage when the battery reaches the target voltage. Therefore, in this constant current/constant voltage charging method, the shape of the charging current curve over time is a constant current while the battery is below the target voltage, and then decreases exponentially after the battery reaches the target voltage. Also, the shape of the charging voltage curve over time is in the form of increasing logarithmically around the inflection point of the target voltage, and then remaining constant at the target voltage after the battery reaches the target voltage. Then, the charging current flowing to the battery gradually decreases and reaches a certain current value (e.g., 0.1C~0.3C), and the battery is judged to be fully charged and charging is stopped.

This constant voltage/constant current charging and discharging method has the disadvantage that the charging time is prolonged due to the characteristics of the battery during the constant voltage charging and discharging intervals, resulting in a longer overall charging time.

Meanwhile, there are two types of charging and discharging devices: parallel and serial. In a parallel type charging and discharging device, there is a separate power supply for each battery channel, and it is configured to perform charging and discharging by controlling the current and voltage for each battery channel. On the other hand, a series-type charging and discharging device has the advantage of controlling the current of all the battery channels at once, which is advantageous in terms of energy efficiency, since the battery channels are connected in series.

However, in a series-type charging and discharging device, a number of batteries with slightly different capacities and internal resistance are connected in series to charge and discharge, and therefore it is difficult to charge and discharge individual batteries at constant voltage due to differences in the characteristics of the batteries. Therefore, when performing constant voltage/constant current charge/discharge with a series-type charging and discharging device, constant current charge/discharge is performed by controlling the current of all channels equally, but when charging and discharging in constant voltage mode, a relay is switched to control the charge/discharge of each cell channel because it is difficult to control the voltage of all channels uniformly. As a result, conventional series-type charging and discharging devices require a lot of time for charging and discharging in constant voltage mode.

Therefore, it is necessary to develop a technology for a charging and discharging device and method that can shorten the time for charging and discharging a plurality of secondary batteries using a series-type charging and discharging device.

US 5,578,914 A discloses: A battery charging system is arranged to reduce a bypass capacity and to enable a charging operation with high current. A plurality of single battery cells connected in series is connected to a charger, and each cell is connected in parallel with a constant voltage circuit having a constant voltage control section and a current saturation detecting section. The constant voltage control section detects the terminal voltage, compares the detected terminal voltage with a preset voltage, and control the terminal voltage so as to be held constant by causing the charging current to bypass in accordance with the error resulting from the comparison. The current saturation detecting section sends a command signal through an OR circuit to the charger when the bypass current becomes saturated, and the charger reduces the charging current in response to the command signal. Therefore, the capacity of the bypass current can be set at a lower level, and the high current charging is possible.

KR 20170100341 A discloses a secondary battery charging/discharging apparatus for charging/discharging battery cells in a battery cell activation process, wherein the apparatus comprises: two or more trays each of which is mounted with battery cells including first electrode terminals and second electrode terminals; a first charging/discharging connection module which includes two or more first connection units, wherein each of the first connection units has a structure including first connection pins to be connected to the first electrode terminals of the battery cells mounted in one of the trays; and a second charging/discharging connection module which includes two or more second connection units, wherein each of the second connection units has a structure including second connection pins to be connected to the second electrode terminals of the battery cell mounted in one of the trays. According to the disclosure, the first and second charging/discharging connection modules charge/discharge the battery cells mounted in the trays while two or more trays are stacked on each other, so that the battery cells mounted in the trays can be charged/discharged simultaneously.

EP 1 014 533 A2 discloses: A system for managing the operation of a battery such as a lithium ion battery having a plurality of serially connected individual cells comprises a bypass module electrically in parallel with each individual cell or, alternatively, with at least one of the cells or alternatively again with an individual cell and its associated grouping of one or more parallel cells. The module includes a sensor for detecting an operating condition of its associated cell and a charger operable for charging the cell. A charge controller is electrically connected with each bypass module and is operable in response to an operating condition of a cell detected by the sensor which is outside a predetermined range of magnitudes to change the bypass module to the conductive mode and thereby shunt current around the battery cell, while leaving unaffected each of the remaining cells. The charge controller includes a processor with mode selecting means for initiating operation of the charger for charging each of the plurality of cells, and a capability for establishing voltage and current set points for each of the bypass modules to thereby prevent overcharging of each associated cell. The processor is also operable for performing a multi step charge profile for each of the bypass modules such that when a predetermined voltage is achieved at the conclusion of a step, a subsequent step is performed at a reduced charge current until a final predetermined voltage is achieved at a charge current which has been reduced to zero.

### [Disclosure]

### [Technical Problem]

The technical idea of the present invention is to provide a charging and discharging device for charging and discharging a plurality of battery cells in series to reduce the time required for charging and discharging in a constant current-constant voltage (CC-CV) mode when charging and discharging in a constant voltage mode.

### [Technical Solution]

The invention is set out in the appended claims. According to claim 1, a series-type charging and discharging device is provided. The series-type charging and discharging device, for charging and discharging a plurality of battery cells in series, includes: one or two or more trays for receiving a plurality of battery cells; a cooling fan for adjusting a temperature of the plurality of battery cells in which charging and discharging take place; a power source for providing a charging and discharging current to the plurality of battery cells and for providing a current to the cooling fan; a charging and discharging control board for controlling a respective charging and discharging current of the plurality of battery cells; and a control unit with a charging and discharging control algorithm, wherein the charging and discharging control algorithm includes a first to N charging and discharging steps, wherein N is an integer from 2 to 10, each charging and discharging step is configured to charge and discharge in a constant current mode, but with a stepwise decrease in the value of the charging and discharging current.

According to claim 1, the charging and discharging control algorithm is configured to charge and discharge the series-connected battery cells in a constant current mode during each of the charging and discharging phases, cutting off the current flowing to a battery cell whenever a battery cell reaches a target voltage, and cutting off when the last battery cell that has not reached the target voltage reaches the target voltage.

In one exemplary embodiment, the charging and discharging control board includes a charge and discharge switch connected in series to each of the battery cells; a bypass switch connected to both ends of the charge and discharge switch; and a switch controller that controls the respective on-off operation of the charge and discharge switch and the bypass switch.

The series-type charging and discharging device according to one exemplary embodiment further includes a voltage sensing portion configured to sense the voltage of each of the plurality of battery cells and to transmit the sensed voltage information to the control unit, wherein the control unit, based on the voltage information received from the voltage sensing portion, controls the switch controller such that whenever a battery cell reaches a cut-off voltage, the charge and discharge switch connected in series to that battery cell is turned off and the bypass switch is turned on to bypass the charge and discharge current of that battery cell.

In one exemplary embodiment, the charging and discharging control board is located in a space in a side portion of the cooling fan.

In one exemplary embodiment, the cooling fans include: an upper cooling fan positioned on an upper portion of the tray relative to a direction perpendicular to the ground; and a lower cooling fan positioned on a lower portion of the tray relative to a direction perpendicular to the ground.

The series-type charging and discharging device according to one embodiment, further including: a first charging and discharging module having a plurality of first connection members for connecting with each first electrode lead of the plurality of battery cells; and a second charging and discharging module having a plurality of second connection members for connecting with each second electrode lead of the plurality of battery cells.

In one exemplary embodiment, the charging and discharging control board includes: a first charging and discharging control board in connection with the first charging and discharging module; and a second charging and discharging control board in connection with the second charging and discharging module.

In one exemplary embodiment, the tray is placed between the first charging and discharging module and the second charging and discharging module with respect to a direction horizontal to the ground.

In one exemplary embodiment, the first charging and discharging module is configured to be movable in the direction of the plurality of first electrode leads and the opposite direction, and the second charging and discharging module is configured to be movable in the direction of the plurality of second electrode leads and the opposite direction.

In one exemplary embodiment, the plurality of first connection members are each configured to press against both sides of the first electrode lead, and the plurality of second connection members are each configured to press against both sides of the second electrode lead.

In one exemplary embodiment, the charging and discharging control algorithm is such that a reference current value that completely terminates the charging and discharging is set, and the current value of the last charging and discharging step is set equal to the reference current value.

In one exemplary embodiment, the trays are two or more, and the trays are configured to be stackable relative to a direction perpendicular to the ground.

According to claim 13, there is provided a method of charging and discharging a battery cell using the series-type charging and discharging device of any one of claims 1 to 12.

### [Advantageous Effects]

In exemplary embodiments of the present invention, a series-type charging and discharging device can be controlled to simultaneously charge and discharge a plurality of battery cells connected in series with a constant current, but sequentially cut off the current supply to battery cells that have reached a cut-off voltage, thereby preventing overcharging/overdischarging.

In addition, compared to a conventional series-type charging and discharging device that performs charging and discharging in a constant-current-constant-voltage mode, it is not necessary to repeat charging and discharging in a constant-voltage mode as many times as the number of cells connected in series, thereby reducing the time required for charging and discharging.

### [Brief Description of the Drawings]

FIG. 1 is a block diagram of a series-type charging and discharging device according to exemplary embodiments of the present invention.
FIG. 2 is a front view of a series-type charging and discharging device according to exemplary embodiments of the present invention.
FIG. 3 is a conceptual diagram to illustrate a charging and discharging control algorithm according to one embodiment of the present invention.
FIG. 4 is a block diagram of a series-type charging and discharging device according to one embodiment of the present invention.
FIG. 5 is a flowchart to illustrate a charging and discharging control algorithm according to one embodiment of the present invention.
FIG. 6 is a diagram illustrating a time-dependent charging and discharging current value applied to a single battery cell when charging and discharging is performed according to the charging and discharging control algorithm of the present invention.
FIG. 7 is a block diagram of a series-type charging and discharging device according to another embodiment of the present invention.
FIG. 8 is a perspective view of a charging and discharging module according to another embodiment of the present invention.
FIG. 9 is a top view of a series-type charging and discharging device according to another embodiment of the present invention.
FIG. 10 is a side view of the charging and discharging module shown in FIG. 9.

### [Detailed Description of the Preferred Embodiments]

The exemplary embodiments described herein and the configurations illustrated in the drawings in present disclosure are just a preferred embodiments of the invention and are not representative of all of the technical ideas of the invention.

Furthermore, in the description of the invention, detailed descriptions of relevant known configurations or features are ruled out if it is determined that the detailed description would obscure the essence of the invention.

Throughout the present specification, unless explicitly described to the contrary, the word "comprise" and variations such as "comprises" or "comprising", will be understood to imply the inclusion of stated elements but not the exclusion of any other elements.

In the present specification, the terms "lithium secondary battery," "secondary battery," and "battery" may be interchangeably used with respect to each other.

Further, terms such as control unit as used in the specification refer to a unit that handles at least one function or operation, which may be implemented in hardware or software, or a combination of hardware and software.

In addition, throughout the specification, when a part is referred to as being "connected" to another part, this includes not only being "directly connected" but also being "indirectly connected" with another element in between.

The present invention provides a series-type charging and discharging device in a first embodiment.

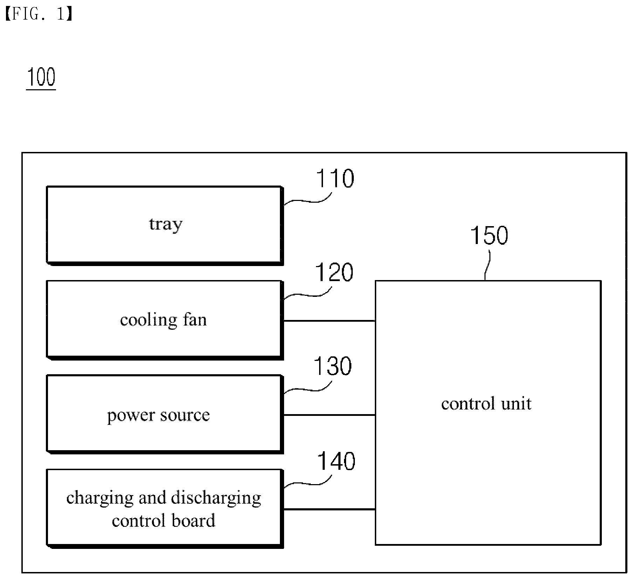

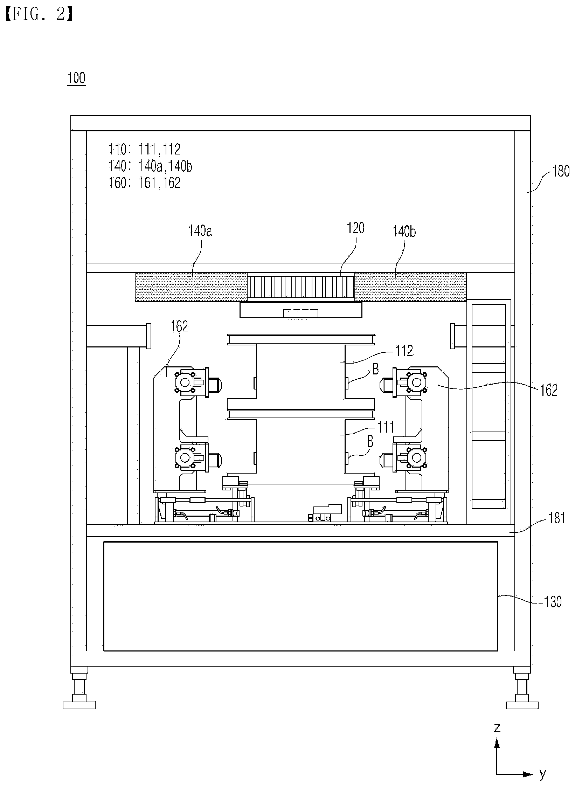

FIG. 1 is a block diagram of a series-type charging and discharging device according to exemplary embodiments of the present invention, and FIG. 2 is a front view of a series-type charging and discharging device according to exemplary embodiments of the present invention.

Referring to FIG. 1 and FIG. 2, a series-type charging and discharging device 100 according to exemplary embodiments of the present invention may include a tray 110, a cooling fan 120, a power source 130, a charging and discharging control board 140, and a control unit 150.

According to exemplary embodiments of the present invention, the control unit 150 is equipped with a charging and discharging control algorithm, wherein the charging and discharging control algorithm comprises a first to N charging and discharging steps, wherein N is an integer from 2 to 10, and each charging and discharging step is configured to charge and discharge in a constant current mode, but with a stepwise decrease in the charging and discharging current value.

In order to perform a constant current/constant voltage method of charging and discharging using a conventional series-type charging and discharging device, a plurality of battery cells connected in series are charged and discharged in constant current mode, and when the first battery cell reaches the target voltage, not only the first battery cell that reaches the target voltage is charged and discharged in constant voltage mode, but also the remaining battery cells that have not reached the target voltage. At this point, the remaining battery cells were charged and discharged at a reduced current. When the constant voltage mode charging and discharging of the first battery cell to reach the target voltage was completed, the charging and discharging of that battery cell was terminated, and the above process was repeated for the remaining battery cells. In this case, the constant voltage mode charging and discharging had to be repeated for the number of battery cells connected in series, which increased the overall charging and discharging time.

In charging and discharging a plurality of battery cells connected in series in a constant-current-constant-voltage (CC-CV) mode, the present invention introduces a multi-step constant-current charging and discharging method that can replace charging and discharging in a constant-voltage mode, thereby reducing the time required for charging and discharging.

A charging and discharging control algorithm according to the present invention provides for multi-step charging and discharging of a plurality of battery cells, wherein each charging and discharging step is performed in a constant current mode and is set to gradually decrease the charging and discharging current value.

The charging and discharging steps include from 2 to 10 steps, more particularly from 3 to 8 steps, and more particularly from 4 to 7 steps.

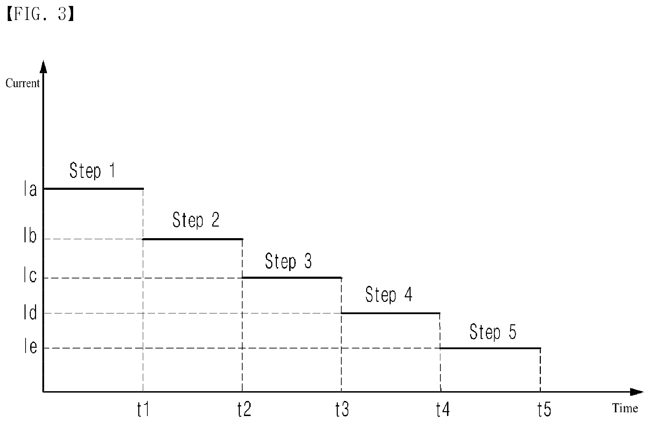

FIG. 3 is a conceptual diagram to illustrate a charging and discharging control algorithm according to one embodiment of the present invention.

Referring to FIG. 3, the charging and discharging steps according to one embodiment may include five charging and discharging steps, wherein the first charging and discharging step, step 1, provides a constant current charge at a current value of Ia, the second charging and discharging step, step 2, provides a constant current charge at a current value of Ib, and the third charging and discharging step, step3, provides a constant current charge at a current value of Ic, in the fourth charging and discharging step, step 4, provides a constant current charge at a current value of Id, and in the fifth charging and discharging step, step 5, provides a constant current charge at a current value of Ie, and the current values of each charging and discharging step satisfy the following relationship.
$Ia > Ib > Ic > Id > Ie$

Specifically, the current values Ia to Ie may be set such as 1 C, 0.8 C, 0.6 C, 0.4 C, 0.2 C, etc.

In such a charging and discharging control algorithm, each charging and discharging interval is set to have a constant current mode of charging and discharging, but the charging and discharging current value is gradually reduced by performing a plurality of charging and discharging step, so that the second charging and discharging step or the Nth charging and discharging step, as a whole, has an effect similar to that of a constant voltage mode of charging and discharging, but in each charging and discharging step, a constant current mode of charging and discharging is performed, and the constant voltage mode of charging and discharging does not need to be repeated, and the time required for charging and discharging can be reduced accordingly.

On the other hand, even if the battery cells are of the same model, there are slight differences in the capacity and resistance of each battery cell, so when a plurality of battery cells in series are charged and discharged with a constant current, the time it takes to reach the target voltage will be different for each battery cell. In other words, instead of reaching the target voltage at the same time, the cells will reach the target voltage sequentially with a time lag.

Since continuing to supply charge and discharge current to battery cells that have reached the target voltage may result in overcharging or overdischarging, the series-type charging and discharging device 100 according to the present invention controls the charging and discharging to cut off the current flowing to those battery cells at each charging and discharging step, whenever a battery cell has reached the target voltage, and to cut off when the last battery cell that has not reached the target voltage reaches the target voltage.

The series-type charging and discharging device 100, according to one exemplary embodiment, may include switches for blocking charge and discharge current flowing to each of the battery cells, or for supplying charge and discharge current to the battery cells.

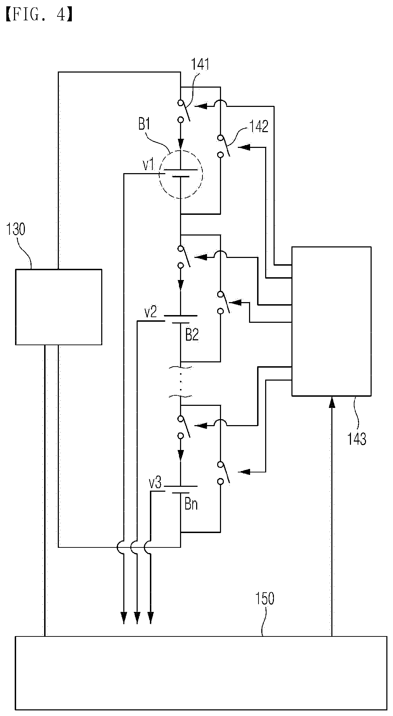

FIG. 4 is a block diagram of a series-type charging and discharging device according to one embodiment of the present invention. Referring to FIG. 4, it may include a charge and discharge switch 141 connected in series to each of the battery cells B1, B2..Bn; and a bypass switch 142 connected to both ends of the charge and discharge switch 141.

During charging and discharging in constant current mode, if a battery cell that has reached the target voltage occurs, the control unit 150 may control the bypass switch 142 of the battery cell that has reached the target voltage to be turned on and the charging and discharging switch 141 of the battery cell that has reached the target voltage to be turned off. As a result, the charge and discharge currents flowing to the battery cells that have reached the target voltage can be cut off, while charge and discharge currents can continue to be supplied to the remaining battery cells.

During this constant current charging and discharging, whenever a battery cell reaches the target voltage, the current flowing to that battery cell is cut off, until eventually the last battery cell that has not been turned off by the charge and discharge switch 141 also reaches the target voltage. The charging and discharging control algorithm of the present invention is designed to terminate one charging and discharging phase by cutting off constant current charging of the corresponding current value when the last battery cell reaches the target voltage.

At the end of one charging and discharging phase, in order to perform the next phase of charging and discharging with a reduced current value, the control unit controls the respective charge and discharge switches of the plurality of battery cells to be all in the ON state after the cut-off of the one charging and discharging phase, allowing the charging and discharging current to flow for all battery cells at the start of the next phase of charging and discharging.

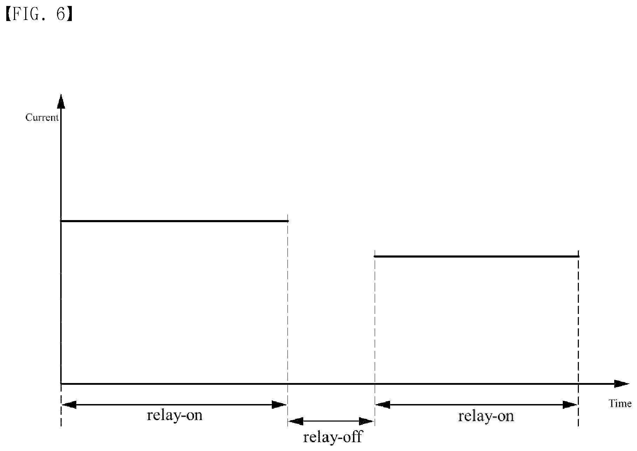

FIG. 6 is a diagram illustrating a time-dependent charging and discharging current value applied to a single battery cell when charging and discharging is performed according to the charging and discharging control algorithm of the present invention. Referring to FIG. 6, any battery cell being charged or discharged according to the charging and discharging control algorithm of the present invention is subjected to constant current charging or discharging in a relay-on state with the charge and discharge switch turned on, and when the target voltage is reached, the charge and discharge switch is switched to a relay-off state with the charge and discharge switch turned off, and the charging and discharging current is cut off. The battery cell that was in the relay-off state is then switched back to the relay-on state to perform the next charging and discharging step, where the applied charging and discharging current value is set to be smaller than the charging and discharging current value of the previous charging and discharging step.

In the charging and discharging control algorithm of the present invention, a reference current value that completely terminates the charging and discharging is set, and a cut-off of the step of charging and discharging to the reference current value is set to completely terminate the charging and discharging.

In other words, in one charging and discharging step, while charging and discharging in constant current mode, whenever a cell reaches the target voltage, the current flowing to that cell is cut off, and when the last cell that has not reached the target voltage reaches the target voltage, it is cut off, and the process is repeated for each charging and discharging step, and when the charging current value reaches the threshold current value, the charging and discharging step is set to end completely.

For example, assuming that the charging and discharging control algorithm consists of five charging and discharging steps from the first charging step to the fifth charging step, and the charging and discharging current values of each charging and discharging step are Ia, Ib, Ic, Id, and Ie, respectively, and the reference current value is set to Ie, when the fifth charging and discharging step is completed, the charging and discharging is completely terminated.

In each of the charging and discharging phases, control of the respective on-off states of the charge and discharge switches and the bypass switch connected to each of the plurality of battery cells may be by the control unit, or may be by a switch controller for controlling the respective on-off operation of the charge and discharge switches and the bypass switch.

Each configuration of the series-type charging and discharging device 100 of the present invention will be described in detail below.

Referring to FIG. 2, a frame 180 is installed on the charging and discharging device 100. The frame 180 may be connected to each other to form a box-shaped skeletal body. Below, relative to a direction perpendicular to the ground (Z direction), the power source 130 described later may be arranged, and on top of the power source 130, a tray 110, a cooling fan 120, and a charging and discharging control board 140 may be arranged. In this way, the charging and discharging device 100 can form an integral structure with the power source 130, the tray 110, the cooling fan 120, the charging and discharging control board 140, and the control unit 150 based on a single frame 180.

The tray 110 is intended to contain a plurality of battery cells, wherein one tray may include a plurality of battery cell compartments (not shown) into which the battery cells are seated. The battery may be mounted within the battery cell compartments in an upright position with respect to the ground. The tray may have an open top to facilitate removal of the battery cells.

The trays 110 may be one or more, and when there are more than one trays 110, the trays 110 may be configured to be stackable relative to a direction perpendicular to the ground (Z direction) in order to contain as many trays as possible within the limited space of the charging and discharging device 100. For example, based on the direction perpendicular to the ground, a first tray 111 may be stacked at the bottom and a second tray 112 may be stacked at the top of the first tray, and a mounting portion (not shown) may be formed on the first tray 111 for securely mounting the second tray 112 stacked at the top.

The cooling fan 120 may serve to regulate the temperature of the plurality of battery cells B being charged and discharged. The cooling fan may be configured to blow air toward a downward direction where the tray-mounted battery cells B are located, thereby cooling the battery cells through the open top tray 110.

In one exemplary embodiment, the cooling fans 120 may include an upper cooling fan positioned on an upper portion of the tray relative to a direction perpendicular to the ground (Z direction); and a lower cooling fan positioned on a lower portion of the tray relative to a direction perpendicular to the ground. However, without limitation, additional cooling fans may be arranged on the sides of the tray.

In order to maintain the temperature of the battery cell being charged and discharged at a set value, the charging and discharging device 100 may further include a temperature sensor (not shown) for measuring the temperature of the battery cell B. The temperature sensor may be configured to measure the temperature of the battery cell being charged or discharged in real time, and to transmit the measured temperature value to the control unit 150. The control portion 150 may maintain the ambient temperature of the battery cell being charged or discharged within a preset temperature range by controlling, for example, the rotational speed of the cooling fan 120 if the temperature received from the temperature sensor is too high or too low.

The power source 130 is intended to provide charge and discharge current to the plurality of battery cells B, and to provide current to the cooling fan 120. In one embodiment, the power source 130 may include a power conversion section (not shown) that converts output power supplied by the current source to a power source suitable for charging and discharging the battery cells B.

The power conversion section may include an AC/DC converter and a DC/DC converter to convert the output power supplied by the power source 130 to a power source suitable for charging and discharging the battery cells. The AC/DC converter may primarily convert AC power to DC power, and the DC/DC converter may supply precise charge and discharge currents to each battery cell from the DC power source.

The power source 130 may be electrically connected to the plurality of battery cells B by a plurality of power cables (not shown). Referring to FIG. 2, the space in which the battery cells B are located and the space in which the power source 130 is located may be separated by the separation wall 181. Both the AC/DC converter and the DC/DC converter may be arranged in the lower space separated by the separation wall 181. In such a case, the DC/DC converter may be located farther away from the battery cell B, thereby increasing the total length of the power cable for connecting the power source 130 to the battery cell B.

In one embodiment, the DC/DC converter may be arranged in close position to the tray 110 or the cooling fan 120. In such a case, the space occupied by the power source 130 can be reduced by separating the AC/DC converter from the DC/DC converter, and the length of the power cable for electrically connecting the power source 130 and the battery cells can be minimized since the DC/DC converter is located in close position to the battery cells.

The charging and discharging control board 140 is for controlling the respective charging and discharging currents of the plurality of battery cells, and includes a charging and discharging circuit for each of the plurality of battery cells. Further, the charging and discharging control board 140 may include a DC/DC converter.

The charging and discharging control board 140 may be connected to the power source 130 via a power cable. The charging and discharging control board 140 may include a charge and discharge switch 141 connected in series with each of the battery cells B1,B2..Bn ; a bypass switch 142 connected to both ends of the charge and discharge switches; and a switch controller 143 controlling the respective on-off operation of the charge and discharge switches and the bypass switch, in order to charge and discharge the battery cells according to the charging and discharging control algorithm.

The charging and discharging control board 140 may include a plurality of channel boards (not shown); and a backplane board (not shown) for housing and connecting the channel boards. The backplane board may be configured to output control signals according to a charge/discharge control algorithm mounted on the control unit, and the channel boards may be configured to execute charging and discharging for each of the plurality of battery cells according to the control signals. The channel boards may be arranged in a plurality on a single backplane board and electrically connected to the backplane board.

The charging and discharging control board 140 may include a first charging and discharging control board 140a corresponding to a first electrode lead B1 of the battery cell B; and a second charging and discharging control board 140b corresponding to a second electrode lead B2 of the battery cell.

Referring to FIG. 2, the charging and discharging control board 140 may be disposed in the space of the side portion of the cooling fan 120. When the charging and discharging control board 140 is disposed in the space of the side portion of the cooling fan 120, the charging and discharging control board 140 does not interfere with the flow of blowing air by the cooling fan, which is desirable in terms of cooling efficiency for the battery cells.

The control unit 150 is configured to carry the charging and discharging control algorithm and to oversee the control required for charging and discharging. The control unit 150 may include a CPU and memory, and the charging and discharging control algorithm may include methods for controlling the PWM signal required for charging and discharging, and for charging and discharging the battery cells in series. PWM signal control means converting a digital signal to an analog signal.

The series-type charging and discharging device 100, according to one embodiment, may further include a voltage sensing portion (not shown) configured to sense the voltage of each of the plurality of battery cells and transmit the sensed voltage information to the control unit.

The charging and discharging control algorithm according to the present invention requires the flow of charging and discharging current to be blocked for cells that have reached a target voltage at each charge and discharge step, and therefore requires a voltage sensing portion to measure the voltage of each of the plurality of battery cells while charging and discharging is in progress.

Based on the voltage information received from the voltage sensing portion, the control unit 150 may control the switch controller 143 to turn off the charge and discharge switches 141 in series with the corresponding battery cell and turn on the bypass switch 142 to bypass the charge and discharge current of the corresponding battery cell whenever a battery cell reaches the cut-off voltage. Each cut-off voltage of the plurality of charge and discharge steps is set to be the same.

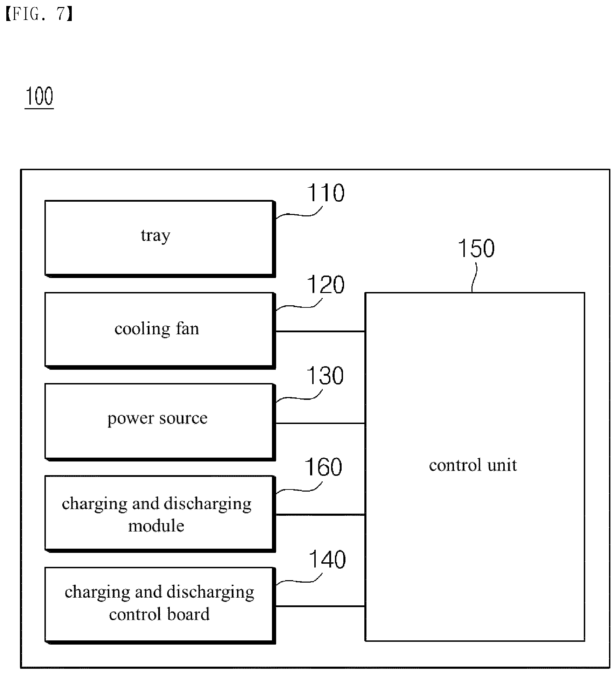

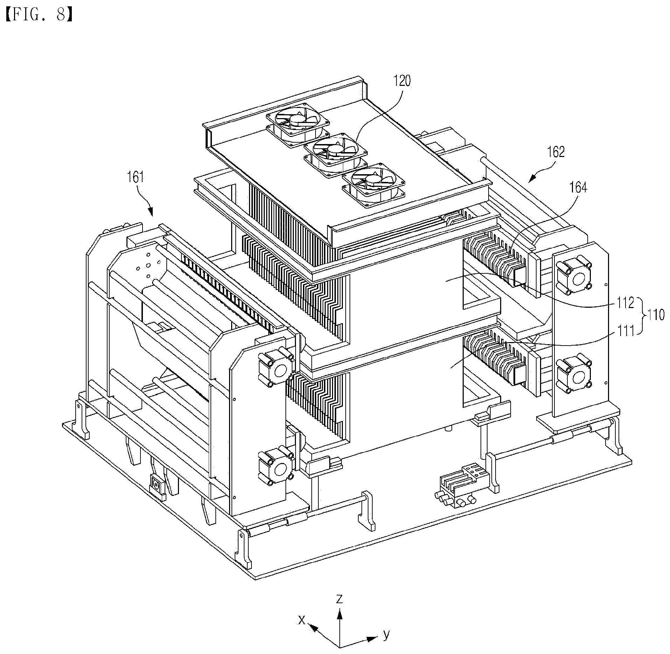

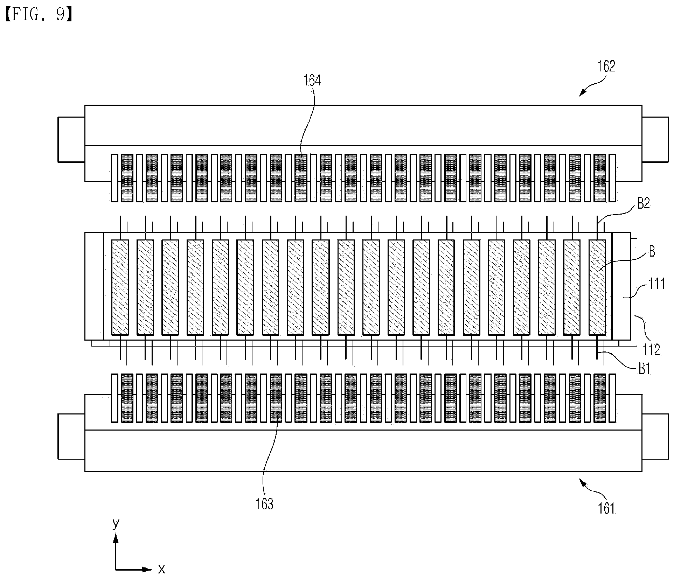

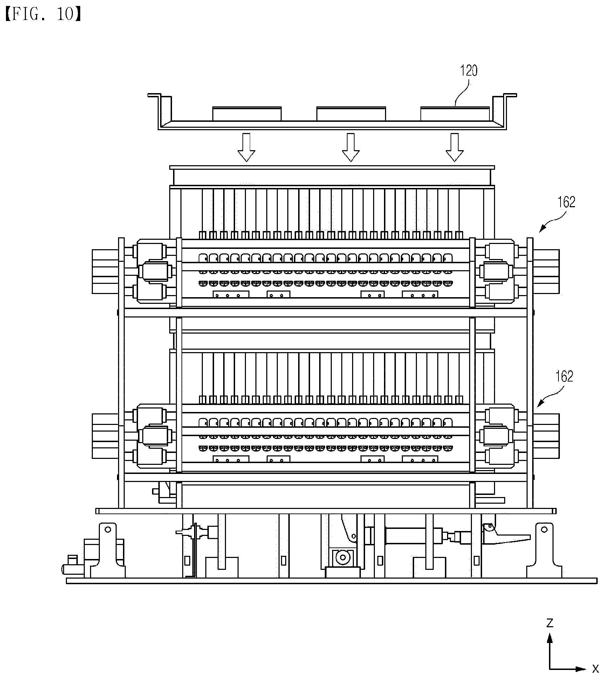

FIG. 7 is a block diagram of a series-type charging and discharging device according to another embodiment of the present invention, FIG. 8 is a perspective view of a charging and discharging module according to another embodiment of the present invention, FIG. 9 is a top view of a series-type charging and discharging device according to another embodiment of the present invention, FIG. 10 is a side view of the charging and discharging module shown in FIG. 9.

Referring to these illustrations, a series-type charging and discharging device 100 according to another embodiment may include a tray 110; a cooling fan 120; a power source 130; a charging and discharging control board 140; a control unit 150; and a charging and discharging module 160.

The tray, cooling fan, power source, charging and discharging control board, and control unit have been described in detail above, so redundant descriptions will be omitted.

The charging and discharging module 160 is for connecting the power source 130 and each of the plurality of battery cells B, and may include a first charging and discharging module 161 and a second charging and discharging module 162. The power source 130 and the charging and discharging module 160 may be connected via a power cable. The first charging and discharging module 161 may have a plurality of first connection members 163 for connecting with each of the first electrode leads B1 of the plurality of battery cells, and the second charging and discharging module 162 may have a plurality of second connection members 164 for connecting with each of the second electrode leads B2 of the plurality of battery cells. In this case, the first electrode leads B1 and the second electrode leads B2 are of different polarities, i.e., if the first electrode leads are positive leads, the second electrode leads are negative leads.

Referring to FIG. 7 to FIG. 9, two trays 111,112 containing a plurality of battery cells B may be stacked along a direction perpendicular to the ground (Z direction). The trays 111,112 may be disposed between the first charging and discharging module 161 and the second charging and discharging module 162 with respect to a direction horizontal to the ground (Y direction). This arrangement is in accordance with the form of a bidirectional battery, wherein the electrode leads B1,B2 of the battery cell are withdrawn in opposite directions to each other.

The first charging and discharging module 161 is spaced apart from each first electrode lead B1 of the plurality of battery cells B, and the second charging and discharging module 162 is spaced apart from each second electrode lead B2 of the plurality of battery cells B, with the first and second trays 111,112 mounted inside the charge and discharge device 100. The spacing distances are intended to facilitate mounting of the first and second trays 111,112 inside the charging and discharging device 100, and after the first and second trays 111,112 are mounted, the first and second charging and discharging modules 161,162 are moved adjacent to the first and second trays 111,112 to allow the first connection member 163 and the second connection member 164 to be electrically connected with the battery cells B.

In other words, the first charging and discharging module may be configured to be movable in the direction of the plurality of first electrode leads and vice versa, and the second charging and discharging module may be configured to be movable in the direction of the plurality of second electrode leads and vice versa.

The first connection member and the second connection member may be provided in a number corresponding to the first electrode lead and the second electrode lead, respectively. The plurality of first connection members may each be configured to press against two sides of the first electrode lead, and the plurality of second connection members may each be configured to press against two sides of the second electrode lead.

The first connection member may press against the first electrode lead and the second connection member may press against the second electrode lead, thereby electrically connecting the power source and the battery cell. At a location in close proximity to the first and second connection members, a voltage sensing connector (not shown) may be provided that is separately connected to the first and second electrode leads for sensing the voltage of the battery cell. When the voltage sensing connector transmits the voltage information sensed by the voltage sensing connector to the control unit 150, the control unit 150 performs charging and discharging control of the battery cell based on the voltage information.

Referring to FIG. 2, the charging and discharging control board 140 may include a first charging and discharging control board 141 in connection with a first charging module 161; and a second charging and discharging control board 140 in connection with a second charging and discharging module 162.

In a second embodiment, the present invention provides a charging and discharging method.

A method of charging and discharging according to the present invention is to charge and discharge a plurality of battery cells in series using a series-type charging and discharging device as set out in any one of claims 1-12.

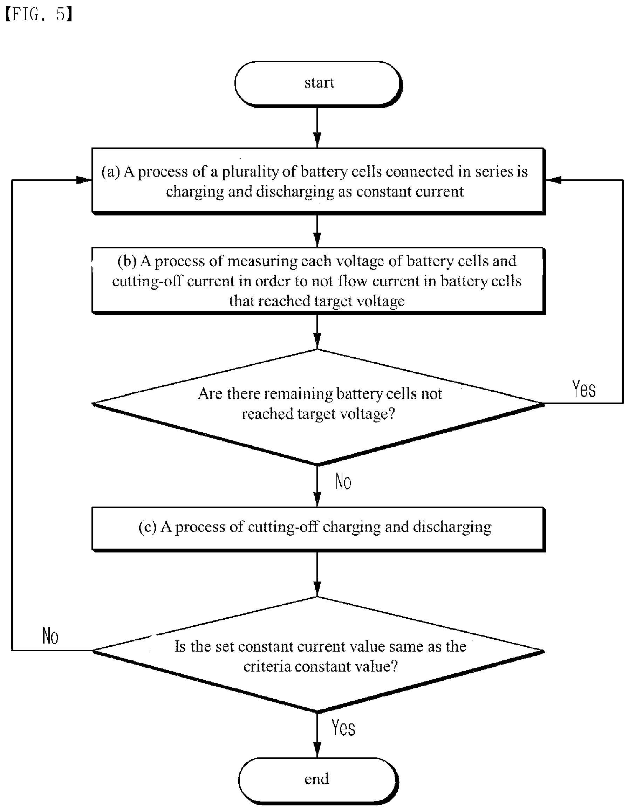

Referring to FIG. 5, each charging and discharging step includes: (a) charging and discharging a plurality of battery cells in series in a constant current mode; (b) measuring a respective voltage of the battery cells and cutting off current to a battery cell that has reached a target voltage; and (c) cutting off current to the last battery cell that has not reached the target voltage when the target voltage is reached.

The method of charging and discharging according to the present invention includes a plurality of charging and discharging steps, each of which includes the steps (a) to (c) above, and after completing the steps (a) to (c), the next step of charging and discharging is performed. At this time, the charging and discharging current value in the next charging and discharging step is set to a value that is reduced from the charging and discharging current value in the previous step.

The method of charging and discharging of the present invention is configured to continue charging and discharging in a constant current mode for the battery cells that have not reached the target voltage, and to cut off the current to the battery cells that have reached the target voltage, while cutting off the current to prevent current from flowing to the battery cells that have reached the target voltage. Thus, the battery cells that have reached the target voltage enter a rest state in which charging and discharging is discontinued while charging and discharging of the remaining battery cells continues.

The method of charging and discharging of the present invention is configured to charge and discharge the battery cells in series in a constant current mode, cutting off the current to the battery cells whenever a battery cell reaches a target voltage, and to cut off the current to that battery cell when the last remaining battery cell that has not reached the target voltage reaches the target voltage, and to initiate the next step of charging and discharging.

The next step of charging and discharging is different in that the charging and discharging current value is reduced compared to the previous step of charging and discharging, but the process of steps (a) to (c) above is the same.

**In** the charging and discharging method of the present invention, a reference current value that completely terminates the charging and discharging step is set. The reference current value is a charging and discharging current value based on which the charging and discharging phase is finally terminated, and may be set differently depending on the specifications of the battery cell.

Therefore, the current value of the last charge and discharge step may be set equal to the above reference current value, i.e., in the charge and discharge step in which a constant current charge is performed with a value equal to the above reference current value, the charge and discharge step according to the present invention is completely terminated by performing the cut-off according to step (c) above.

This method of charging and discharging has the effect of significantly reducing the time required for charging and discharging by replacing constant voltage mode charging and discharging with multi-step constant current mode charging and discharging.

### [Description of Reference Numerals]

100: series-type charging and discharging device
110: tray
120: cooling fan
130: power source
140: charging and discharging control board
150: control unit
160: charging and discharging module
180: frame

## Claims

1. A series-type charging and discharging device for charging and discharging a plurality of battery cells in series, comprising:
one or two or more trays (110-112) for receiving a plurality of battery cells;
a cooling fan (120) for adjusting a temperature of the plurality of battery cells in which charging and discharging take place;
a power source (130) for providing a charging and discharging current to the plurality of battery cells and for providing a current to the cooling fan (120);
a charging and discharging control board for controlling a respective charging and discharging current of the plurality of battery cells; and
a control unit (150) with a charging and discharging control algorithm,
wherein the charging and discharging control algorithm comprises a first to N charging and discharging steps, wherein N is an integer from 2 to 10, each charging and discharging step is configured to charge and discharge in a constant current mode, but with a stepwise decrease in the value of the charging and discharging current,
wherein the charging and discharging control algorithm is configured to charge and discharge the series-connected battery cells in a constant current mode during each of the charging and discharging steps, cutting off the current flowing to a battery cell whenever a battery cell reaches a target voltage, and cutting off when the last battery cell that has not reached the target voltage reaches the target voltage.

2. The series-type charging and discharging device of claim 1, wherein the charging and discharging control board comprises a charge and discharge switch connected in series to each of the battery cells;
a bypass switch (142) connected to both ends of the charge and discharge switch; and
a switch controller (143) that controls the respective on-off operation of the charge and discharge switch and the bypass switch (142).

3. The series-type charging and discharging device of claim 2, further comprising: a voltage sensing portion configured to sense the voltage of each of the plurality of battery cells and to transmit the sensed voltage information to the control unit (150), wherein the control unit (150), based on the voltage information received from the voltage sensing portion, controls the switch controller (143) such that whenever a battery cell reaches a cut-off voltage, the charge and discharge switch connected in series to that battery cell is turned off and the bypass switch (142) is turned on to bypass the charge and discharge current of that battery cell.

4. The series-type charging and discharging device of claim 1, wherein the charging and discharging control board is located in a space in a side portion of the cooling fan (120).

5. The series-type charging and discharging device of claim 1, wherein the cooling fan (120), comprising: an upper cooling fan (120) positioned on an upper portion of the tray (110-112) relative to a direction perpendicular to the ground; and
a lower cooling fan (120) positioned on a lower portion of the tray (110-112) relative to a direction perpendicular to the ground.

6. The series-type charging and discharging device of claim 1, further comprising: a first charging and discharging module having a plurality of first connection members (163) for connecting with each first electrode lead of the plurality of battery cells; and
a second charging and discharging module having a plurality of second connection members (164) for connecting with each second electrode lead of the plurality of battery cells.

7. The series-type charging and discharging device of claim 6, wherein the charging and discharging control board, comprising: a first charging and discharging control board in connection with the first charging and discharging module; and
a second charging and discharging control board in connection with the second charging and discharging module.

8. The series-type charging and discharging device of claim 6, wherein the tray (110-112) is placed between the first charging and discharging module and the second charging and discharging module with respect to a direction horizontal to the ground.

9. The series-type charging and discharging device of claim 6, wherein the first charging and discharging module is configured to be movable in the direction of the plurality of first electrode leads and the opposite direction, and
the second charging and discharging module is configured to be movable in the direction of the plurality of second electrode leads and the opposite direction.

10. The series-type charging and discharging device of claim 6, wherein the plurality of first connection members (163) is each configured to press against both sides of the first electrode lead, and the plurality of second connection members (164) are each configured to press against both sides of the second electrode lead.

11. The series-type charging and discharging device of claim 1, wherein the charging and discharging control algorithm is such that a reference current value that completely terminates the charging and discharging is set, and the current value of the last charging and discharging step is set equal to the reference current value.

12. The series-type charging and discharging device of claim 1, wherein the trays (110-112) are two or more, and the trays (110-112) are configured to be stackable relative to a direction perpendicular to the ground.

13. A method of charging and discharging a battery cell using the series-type charging and discharging device of any one of claims 1 to 12.

## Patentansprüche

1. Lade- und Entladevorrichtung vom Serientyp zum Laden und Entladen einer Vielzahl von Batteriezellen in Serie, umfassend:
eine oder zwei oder mehr Schalen (110-112) zum Aufnehmen einer Vielzahl von Batteriezellen;
ein Kühlgebläse (120) zum Einstellen einer Temperatur der Vielzahl von Batteriezellen, in denen das Laden und Entladen stattfindet;
eine Stromquelle (130) zum Bereitstellen eines Lade- und Entladestroms für die Vielzahl von Batteriezellen und zum Bereitstellen eines Stroms für das Kühlgebläse (120);
eine Lade- und Entladesteuerplatine zum Steuern eines jeweiligen Lade- und Entladestroms der Vielzahl von Batteriezellen; und
eine Steuereinheit (150) mit einem Lade- und Entladesteueralgorithmus,
wobei der Lade- und Entladesteueralgorithmus einen ersten bis N Lade- und Entladeschritte umfasst, wobei N eine ganze Zahl von 2 bis 10 ist, wobei jeder Lade- und Entladeschritt konfiguriert ist, um in einem Konstantstrommodus zu laden und zu entladen, jedoch mit einer schrittweisen Abnahme des Werts des Lade- und Entladestroms,
wobei der Lade- und Entladesteueralgorithmus konfiguriert ist, um die in Serie geschalteten Batteriezellen in einem Konstantstrommodus während jedes der Lade- und Entladeschritte zu laden und zu entladen, den Strom, der zu einer Batteriezelle fließt, abzuschalten, wann immer eine Batteriezelle eine Zielspannung erreicht, und abzuschalten, wenn die letzte Batteriezelle, die die Zielspannung nicht erreicht hat, die Zielspannung erreicht.

2. Lade- und Entladevorrichtung vom Serientyp nach Anspruch 1, wobei die Lade- und Entladesteuerplatine einen Lade- und Entladeschalter umfasst, der in Serie mit jeder der Batteriezellen verbunden ist;
einen Umgehungsschalter (142), der mit beiden Enden des Lade- und Entladeschalters verbunden ist; und
eine Schaltersteuerung (143), die den jeweiligen Ein-Aus-Betrieb des Lade- und Entladeschalters und des Umgehungsschalters (142) steuert.

3. Lade- und Entladevorrichtung vom Serientyp nach Anspruch 2, ferner umfassend: einen Spannungserfassungsabschnitt, der konfiguriert ist, um die Spannung jeder der Vielzahl von Batteriezellen zu erfassen und die erfassten Spannungsinformationen an die Steuereinheit (150) zu übertragen, wobei die Steuereinheit (150), basierend auf den von dem Spannungserfassungsabschnitt empfangenen Spannungsinformationen, die Schaltersteuerung (143) derart steuert, dass, wann immer eine Batteriezelle eine Abschaltspannung erreicht, der in Serie mit dieser Batteriezelle verbundene Lade- und Entladeschalter ausgeschaltet wird und der Umgehungsschalter (142) eingeschaltet wird, um den Lade- und Entladestrom dieser Batteriezelle zu umgehen.

4. Lade- und Entladevorrichtung vom Serientyp nach Anspruch 1, wobei sich die Lade- und Entladesteuerplatine in einem Raum in einem Seitenabschnitt des Kühlgebläses (120) befindet.

5. Lade- und Entladevorrichtung vom Serientyp nach Anspruch 1, wobei das Kühlgebläse (120) umfasst: ein oberes Kühlgebläse (120), das an einem oberen Abschnitt der Schale (110-112) relativ zu einer Richtung senkrecht zu dem Boden positioniert ist; und
ein unteres Kühlgebläse (120), das an einem unteren Abschnitt der Schale (110-112) relativ zu einer Richtung senkrecht zu dem Boden positioniert ist.

6. Lade- und Entladevorrichtung vom Serientyp nach Anspruch 1, ferner umfassend: ein erstes Lade- und Entlademodul mit einer Vielzahl von ersten Verbindungselementen (163) zum Verbinden mit jeder ersten Elektrodenleitung der Vielzahl von Batteriezellen; und
ein zweites Lade- und Entlademodul mit einer Vielzahl von zweiten Verbindungselementen (164) zum Verbinden mit jeder zweiten Elektrodenleitung der Vielzahl von Batteriezellen.

7. Lade- und Entladevorrichtung vom Serientyp nach Anspruch 6, wobei die Lade- und Entladesteuerplatine umfasst: eine erste Lade- und Entladesteuerplatine in Verbindung mit dem ersten Lade- und Entlademodul; und
eine zweite Lade- und Entladesteuerplatine in Verbindung mit dem zweiten Lade- und Entlademodul.

8. Lade- und Entladevorrichtung vom Serientyp nach Anspruch 6, wobei die Schale (110-112) zwischen dem ersten Lade- und Entlademodul und dem zweiten Lade- und Entlademodul in Bezug auf eine Richtung horizontal zu dem Boden platziert ist.

9. Lade- und Entladevorrichtung vom Serientyp nach Anspruch 6, wobei das erste Lade- und Entlademodul konfiguriert ist, um in der Richtung der Vielzahl von ersten Elektrodenleitungen und der entgegengesetzten Richtung beweglich zu sein, und
das zweite Lade- und Entlademodul konfiguriert ist, um in der Richtung der Vielzahl von zweiten Elektrodenleitungen und der entgegengesetzten Richtung beweglich zu sein.

10. Lade- und Entladevorrichtung vom Serientyp nach Anspruch 6, wobei die Vielzahl von ersten Verbindungselementen (163) jeweils konfiguriert ist, um gegen beide Seiten der ersten Elektrodenleitung zu drücken, und die Vielzahl von zweiten Verbindungselementen (164) jeweils konfiguriert ist, um gegen beide Seiten der zweiten Elektrodenleitung zu drücken.

11. Lade- und Entladevorrichtung vom Serientyp nach Anspruch 1, wobei der Lade- und Entladesteueralgorithmus derart ist, dass ein Referenzstromwert, der das Laden und Entladen vollständig beendet, eingestellt wird, und der Stromwert des letzten Lade- und Entladeschritts gleich dem Referenzstromwert eingestellt wird.

12. Lade- und Entladevorrichtung vom Serientyp nach Anspruch 1, wobei die Schalen (110-112) zwei oder mehr sind, und die Schalen (110-112) konfiguriert sind, um relativ zu einer Richtung senkrecht zu dem Boden stapelbar zu sein.

13. Verfahren zum Laden und Entladen einer Batteriezelle unter Verwendung der Lade- und Entladevorrichtung vom Serientyp nach einem der Ansprüche 1 bis 12.

## Revendications

1. Dispositif de charge et décharge du type série pour charger et décharger une pluralité de cellules de batterie en série, comprenant :
un ou deux plateaux (110-112), ou davantage, pour recevoir une pluralité de cellules de batterie ;
un ventilateur de refroidissement (120) pour ajuster une température de la pluralité de cellules de batterie dans lequel se produisent la charge et la décharge ;
une source d'alimentation (130) pour fournir un courant de charge et de décharge à la pluralité des cellules de batterie, et pour apporter un courant au ventilateur de refroidissement (120) ;
un tableau de contrôle de charge et de décharge pour la gestion d'un courant de charge et de décharge respectifs de la pluralité des cellules de batterie ; et
un module de commande (150) avec un algorithme de commande de charge et de décharge,
l'algorithme de commande de charge et de décharge comprenant des étapes de charge et de décharge de la première à N, N étant un entier de 2 à 10, chaque étape de charge et de décharge étant configurée pour charger et décharger en mode courant constant, mais avec une diminution progressive de la valeur du courant de charge et de décharge,
l'algorithme de commande de charge et de décharge étant configuré pour charger et décharger les cellules de batterie connectées en série en mode à courant constant au cours de chacune des étapes de charge et de décharge, en coupant le courant circulant vers une cellule de batterie chaque fois qu'une cellule de batterie atteint une tension cible, et en coupant lorsque la dernière cellule de batterie qui n'a pas atteint la tension cible atteint la tension cible.

2. Dispositif de charge et décharge du type série selon la revendication 1, le tableau de commande de charge et de décharge comprenant un interrupteur de charge et de décharge connecté en série à chacune des cellules de la batterie ;
un commutateur de dérivation (142) relié aux deux bouts de l'interrupteur de charge et de décharge ; et
un contrôleur de commutation (143) commandant le fonctionnement marche/arrêt respectif de l'interrupteur de charge et de décharge, ainsi que du commutateur de dérivation (142).

3. Dispositif de charge et de décharge du type série selon la revendication 2, comprenant en outre : une partie de détection de tension configurée pour détecter la tension de chacune de la pluralité de cellules de batterie, et transmettre les informations sur la tension détectées au module de commande (150), le module de commande (150) commandant le contrôleur de commutation (143) en fonction des informations reçues de la partie de détection de la tension, de sorte que chaque fois qu'une cellule de batterie atteint une tension de coupure, l'interrupteur de charge et de décharge connecté en série à cette cellule de batterie est désactivé, et le commutateur de dérivation (142) est activé afin de contourner le courant de charge et de décharge de cette cellule de batterie.

4. Dispositif de charge et de décharge du type série selon la revendication 1, le tableau de commande de charge et de décharge étant situé dans un espace dans une partie latérale du ventilateur de refroidissement (120).

5. Dispositif de charge et de décharge du type série selon la revendication 1, le ventilateur de refroidissement (120) comprenant : un ventilateur de refroidissement supérieur (120) positionné sur une partie supérieure du plateau (110-112) relativement à une direction perpendiculaire au sol ; et
un ventilateur de refroidissement inférieur (120) positionné sur une partie inférieure du plateau (110-112) relativement à une direction perpendiculaire au sol.

6. Dispositif de charge et de décharge du type série selon la revendication 1, comprenant en outre : un premier module de charge et de décharge comportant une pluralité de premiers éléments de connexion (163) pour la connexion à chaque conducteur de première électrode de la pluralité des cellules de batterie ; et
un deuxième module de charge et de décharge comportant une pluralité de deuxièmes éléments de connexion (164) pour la connexion à chaque conducteur de deuxième électrode de la pluralité de cellules de batterie.

7. Dispositif de charge et de décharge du type série selon la revendication 6, le tableau de commande de charge et de décharge comprenant : un premier tableau de commande de charge et de décharge en connexion avec le premier module de charge et de décharge ; et
un deuxième tableau de commande de charge et de décharge en connexion avec le deuxième module de charge et de décharge.

8. Dispositif de charge et de décharge du type série selon la revendication 6, le plateau (110-112) étant placé entre le premier module de charge et de décharge et le deuxième module de charge et de décharge, relativement à une direction horizontale au sol.

9. Dispositif de charge et de décharge du type série selon la revendication 6, le premier module de charge et de décharge étant configuré pour pouvoir être déplacé dans la direction de la pluralité des premiers conducteurs d'électrode et dans le sens opposé, et
le deuxième module de charge et décharge étant configuré pour pouvoir être déplacé dans la direction de la pluralité des deuxièmes conducteurs d'électrode et dans le sens opposé.

10. Dispositif de charge et de décharge du type série selon la revendication 6, la pluralité des premiers éléments de connexion (163) étant configurés pour appuyer sur les deux côtés du conducteur de première électrode, et la pluralité des deuxièmes éléments de connexion (164) étant configurés chacun pour faire pression sur les deux côtés du conducteur de deuxième électrode.

11. Dispositif de charge et de décharge du type série selon la revendication 1, l'algorithme de commande de charge et de décharge étant tel qu'une valeur de courant de référence arrêtant entièrement la charge et à la décharge étant établi, et que la valeur de courant de la dernière étape de charge et de décharge est fixée pour être égale à la valeur du courant de référence.

12. Dispositif de charge et de décharge du type série selon la revendication 1, les plateaux (110-112) étant au nombre de deux ou davantage, et les plateaux (110-112) étant configurés pour pouvoir être empilés relativement à une direction perpendiculaire au sol.

13. Procédé de charge et de décharge d'une cellule de batterie faisant usage du dispositif de charge et de décharge du type série selon une quelconque des revendications 1 à 12.
